# EUROPEAN PATENT APPLICATION

(11) **EP 2 284 610 A1**
(43) Date of publication of application: **16.02.2011**
(21) Application number: 09167930.8
(22) Date of filing: 14.08.2009
(51) Int. Cl.: G03F 7/00

(54) **A method of fabricating an imprinted substrate having regions with modified wettability**

(71) Applicant: Nederlandse Organisatie voor Toegepast -Natuurwetenschappelijk Onderzoek TNO, 2628 VK Delft (NL)
(72) Inventor: Ivan, Marius Gabriel, 2628 VK Delft (NL); Verhaart, Gerardus Johannes, 5657 EN Eindhoven (NL)
(74) Representative: Hatzmann, Martin

(57) **Abstract**

The invention relates to a method of fabrication of a substrate having a first region with a first wettability degree and a second region with a second wettability degree, the method comprising the steps of: providing the substrate (2) with a roughened surface of a photosensitive layer (4) using embedded nano- and/or microparticles (6); transferring (7) a pattern into the photosensitive layer for obtaining a substrate structure; developing the substrate structure (B) for obtaining the first region corresponding to the substrate (5a) and the second region (5b) corresponding to the roughened photosensitive layer.

## Description

### FIELD

The invention relates to a filed of template manufacturing for enabling selective patterning and deposition of functional materials using in electronic devices. In particular, the invention relates to the field of modifying wettability properties of an imprinted substrate.

### BACKGROUND

An embodiment of the method as is set forth in the opening paragraph is known from US 2008/0199653. In the known method nanospheres are closely provided on a surface of a substrate after which a metal material is provided among these nanospheres to act as a mask, after which the nanospheres are removed. This is followed by a step of reactive ion etching thereby inducing a two-dimensional pattern height profile in the substrate.

It is a disadvantage of the known method that precise positioning of the nanospheres and the metal mask is necessary for enabling a desired template profile. It is a further disadvantage of the known method that a two-dimensional surface of the resulting template has the same roughness.

### SUMMARY OF THE INVENTION

It is an object of the invention to provide an improved method of a substrate fabrication wherein regions having different wettability degree are inherently provided.

To this end the method of fabrication of a substrate having a first region with a first wettability degree and a second region with a second wettability degree, comprises the steps of:
- providing the substrate with a roughened surface of a photosensitive layer using embedded nano- and/or microparticles;
- transferring a pattern into the photosensitive layer for obtaining a substrate structure;
- developing the substrate structure for obtaining the first region corresponding to the substrate and the second region corresponding to the roughened photosensitive layer.

It is found that desirable tuning of wettability properties may be successfully achieved by providing templates, i.e. imprinted substrates, with structured and non-structured areas. Preferably, nanoparticles are used as a structuring element, wherein the nanoparticles are provided on a surface of the photosensitive layer and due to their substantially spherical geometry they protrude further than a substantially flat photoresist layer. However, microparticles may be used as well. It will be appreciated that a combination of nanoparticles and microparticles may be used as well. Such non-scaled surface irregularities are sufficient for suitably tuning the wettability. It will be appreciated that such tuning may be achieved either by using the nanoparticles as roughening bodies, or by using the nanoparticles as porogens. In both cases it is possible to tune wettability by selecting a suitable size of the nanoparticles, and/or by setting a pre-determined distance between the nanoparticles.

An alternative embodiment of the method according to the invention, comprises the steps of:
- roughening the substrate for forming a structured substrate surface;
- providing a photosensitive layer on the structured substrate surface;
- patterning and developing the photoresensitive layer for revealing regions of the structured substrate surface.

In this particular embodiment the substrate surface is roughened, so that the substrate surface is conceived to have a different, for example, a higher hydrophobic degree than areas of the photosensitive layer.

A still further embodiment of the method according to the invention comprises the steps of:
- exposing the substrate provided with a photosensitivet layer composed on a number of sub-layers having individual roughness by a laser beam having a pre-determined inhomogeneous energy profile for obtaining a cavity in the photoresist layer;
- developing the exposed photosensitive layer yielding a multi-level template.

In this particular embodiment suitable non-linear surfaces may be provided by suitably adjusting profile of the laser beam. It will be appreciated that the laser beam may comprise a number of sub-beams of smaller dimensions for generating non-linear cavities using penumbra region as well as the front region of the beam.

A still further embodiment of the method according to the invention comprises the steps of:
- exposing the substrate provided with a photosensitive layer by radiation;
- developing the photosensitive layer for revealing regions of the substrate;
- depositing nano- and/or microparticles at least on the regions of the substrate;
- removing the photosensitive layer;
- selectively etching the substrate for obtaining the first region corresponding to substrate areas not covered by nano- and/or microparticles and the second region corresponding to areas covered by nano- and/or microparticles.

In this particular embodiment nano- and/or microparticles are used for enabling selective etching of the surface, wherein etching has different rate in the region covered by such particles and in the region not covered by such particles.

In a still further embodiment of the method according to the invention, the method comprises the steps of:
- exposing the substrate provided with a photosensitive layer composed on a number of sub-layers having individual roughness by a laser beam having a pre-determined inhomogeneous energy profile for obtaining a cavity in the photosensitive layer, said cavity comprising surface portions corresponding to said sub-layers;
- developing the exposed photosensitive layer yielding a multi-level substrate.

It is found that a cavity comprising a number of surfaces having an individual surface roughness can easily be provided by exposing a multilayered photosensitive material to a laser beam having an inhomogeneous energy profile.

These and other aspects of the invention will be discussed in more detail with reference to drawings, wherein like reference numerals refer to like elements. It will be appreciated that the drawings are presents for illustrative purposes and may not be used for limiting the scope of the appended claims.

### BRIEF DESCRIPTION OF THE DRAWINGS

Figure 1 presents in a schematic way an embodiment of the method according to the invention.
Figure 2 presents in a schematic way a further embodiment of the method according to the invention.
Figure 3 presents in a schematic way a still further embodiment of the method according to the invention.
Figure 4 presents in a schematic way a still further embodiment of the method according to the invention.
Figure 5 presents in a schematic way a still further embodiment of the method according to the invention.
Figure 6 presents in a schematic way a still further embodiment of the method according to the invention.
Figure 7 presents in a schematic way a still further embodiment of the method according to the invention.

### DETAILED DESCRIPTION OF THE DRAWINGS

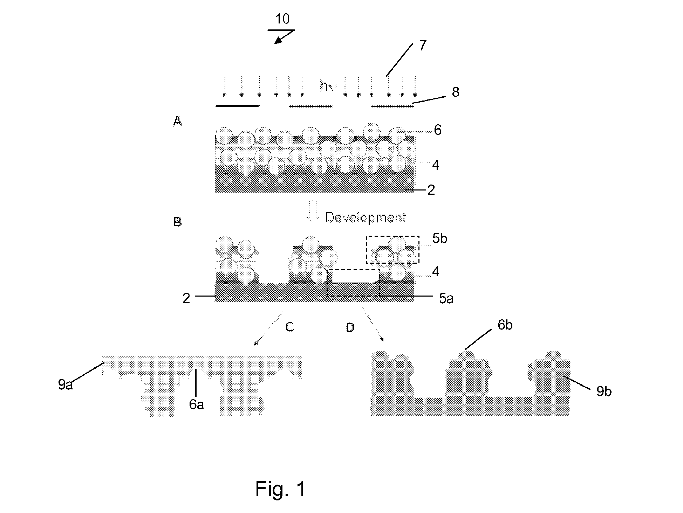

Figure 1 presents in a schematic way an embodiment of the method according to the invention. According to a first embodiment of the method of the invention, at step A a substrate 2 provided with a roughened surface of a photoresist layer 4 by means of embedded nano- and/or microparticles 6 is subjected to a beam of a suitable radiation 7, which may be applied via a mask 8 for transferring a pattern into the photoresist layer 4. It will be appreciated that a maskless application is contemplated as well.

As a result, due to an interaction of the radiation 7 with a material of the photoresist layer 4 (which may be either a positive photoresist or a negative photoresist) respective photoresist regions may become dissolvable in a solvent. During a development step B such regions are removed yielding a structured template having a first region 5a corresponding to a substrate surface and a second region 5b corresponding to a roughened photoresist layer 4. Due to the fact that the photoresist layer 4 comprises embedded nanoparticles 6 its wettability is lower than wettability of the revealed substrate regions 5a.

At steps C and D the resulting template may be replicated into a negative mold 9a or a positive mold 9b. It will be appreciated that in case of the negative mold 9a the roughened surface comprises nano-scale cavities 6a, while for the positive mold the roughened surface comprises nano-scale protrusions 6b. Both cavities and protrusions correspond to the original nanoparticles 6 embedded in the photoresist material 4.

It will be appreciated that although for the substrate 2 any solid or flexible material may be used, preferably, a Si substrate is selected. For the nanoparticles, preferably, Si02 particles are selected, however, other particles may be used, like metal particles, semiconductor particles or polymer particles. Preferably, the nano- and/or microparticles have a dimension of in the range of several nanometers to several microns. The nano- and/or microparticles may be randomly distributed in the photoresist material. It will be appreciated that the nanoparticles suitable for practicing the invention are not soluble in the solvent used for developing the photoresist layer post exposure.

In order to further modify surface roughness of the template structure an additional etching step may be envisaged, wherein the nanoparticles or the resist material may be etched.

In order to obtain a mold for mass production, the template structure obtained at step B is replicated into a master mold. Preferably, prior to replication an anti-sticking layer is applied, for example a fluorine-containing layer. Also, a Si-containing layer may be used or a Si-containing polymer, like silane, siloxane.

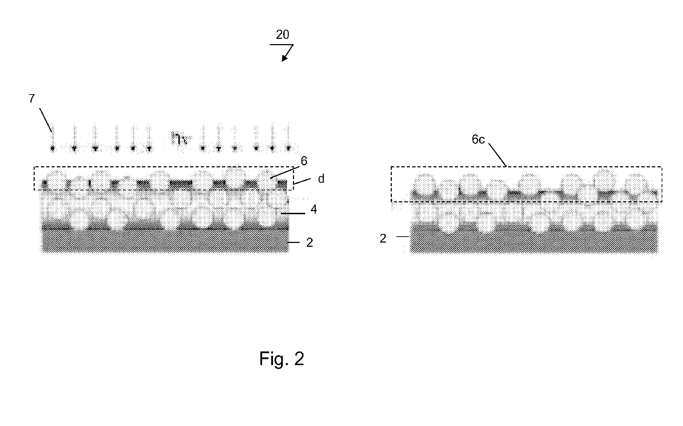

Figure 2 presents in a schematic way a further embodiment of the method according to the invention. This embodiment is similar to the embodiment, discussed with reference to Figure 1, wherein an additional pre-development step is envisaged. Accordingly, a complete surface of a substrate 2 provided with a photoresist layer 4 embedding nanoparticles 6 is partially developed after initial exposure using a suitable radiation 7. As a result, a top layer d is removed revealing a-sub-surface nanoparticles. Preferably, a thickness of the top layer conceived to be removed is less than a diameter of the embedded nanoparticles. Such removal of the top layer is advantageous as the roughness of the future template regions is defined with well shaped nanoparticles 6c which originate from a sub-surface volume of the resist material. In addition, due to removal of the top portion of the photoresist layer the roughness of the photoresist may be increased uniformly over the whole surface area.

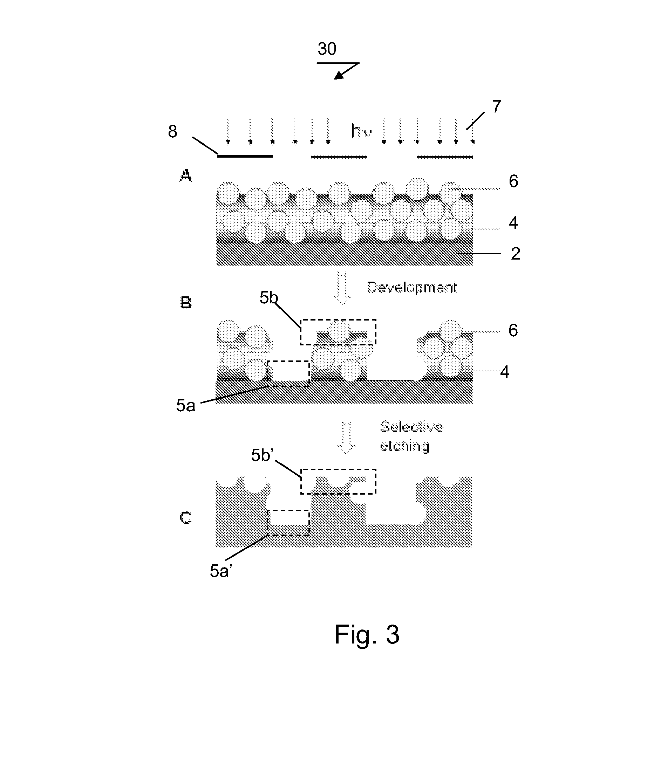

Figure 3 presents in a schematic way a still further embodiment of the method according to the invention. In this particular embodiment steps A and b are similar to the corresponding steps discussed with reference to Figure 1. At step C selective etching is performed wherein the surface nanoparticles are removed leaving voids behind, see region 5b'. Accordingly, in this embodiment the nanoparticles are used as porogenes. Still, roughness of the region 5b'is higher than roughness of the region 5a', corresponding to the revealed substrate surface. In case when for the nanoparticles Si02 particles are selected they may be etched away in the fluorine or chlorine atmosphere. Also in this case either a positive or a negative replication technique may be used for obtaining a production mold.

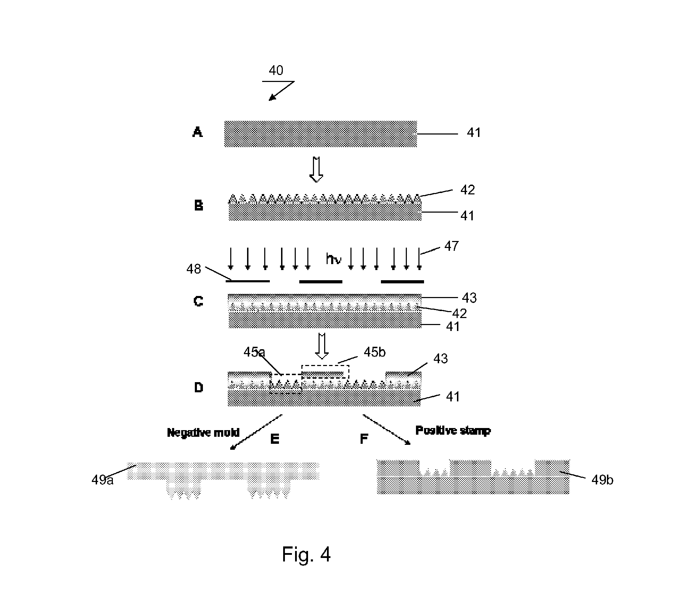

Figure 4 presents in a schematic way a still further embodiment of the method according to the invention. In this particular embodiment an alternative approach for inherently providing a template with different roughness degree is contemplated.

Initially, at step A a substrate 41 is selected, preferably a monocrystalline Si wafer. At step 42 the Si wafer is subjected to anisotropic etching, preferably along the 100 direction of the Si crystal. As a result, the surface is provided with jugular projections 42, i.e. is controllably roughened. Preferably, for the etchant a hydroxide solution is used, for example, KOH.

At step C a layer of photoresist 43 is provided and is exposed to a suitable radiation 47, for example via a mask 48. Also in this embodiment maskless exposure is contemplated.

At step D post development a first region 45a corresponding to a region of the substrate is obtained and a second region 45b corresponding to the patterned photoresist layer is obtained. It will be appreciated that contrary to the embodiment discussed with reference to Figure 1, in this case the substrate regions have a higher roughness than the photoresist regions. This may be advantageous for cases when a deposition of a liquid is desirable on the surface 45b rather than on the surface 45a. However, it will be appreciated that also in this embodiment the photoresist may be provided with nanoparticles. In this case respective roughness of the regions 45a, 45b can be pre-set based on a relation between absolute dimensions of the jugular regions 42 and the diameter of the nanoparticles.

Finally, at steps E and F either a genitive mold 49a or a positive mold 49b may be provided.

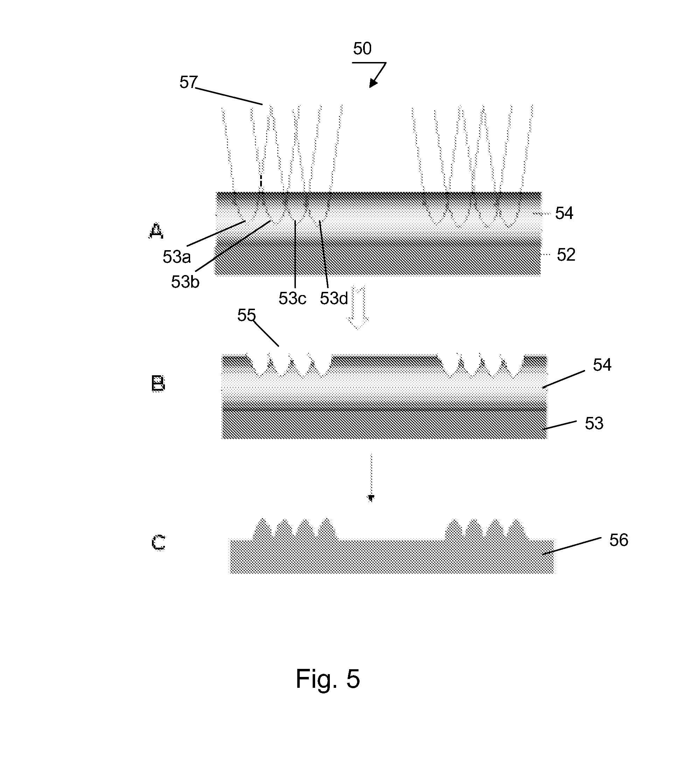

Figure 5 presents in a schematic way a still further embodiment of the method according to the invention. In this embodiment surface of the photoresist 54 provided on a substrate 52 is roughened using a laser beam 57, which may be composed of a number of sub-beams 53a, 53b, 53c, 53d. It will be appreciated that although preferably the sub-beams have substantially the same energy, it is possible that the sub-beams have different energies which will result in different range of penetration into the photoresist 54.

According to the present embodiment the laser beam 57 has a nonuniform intensity distribution which results in a provision of a number of adjacent cavities forming a local irregularity 55. The walls of the cavities are substantially non-linear due to penumbra effects of the laser beam. The bottom portion of the cavities is also non-linear due to the non-linear intensity profile of the laser beam. It will be appreciated that the sub-beams having a substantially homogeneous intensity are contemplated as well.

At step B post developing the photoresist layer 54 is roughened in accordance with the non-homogeneous profile of the laser beam 57. At step C post suitable replication a production mold is provided.

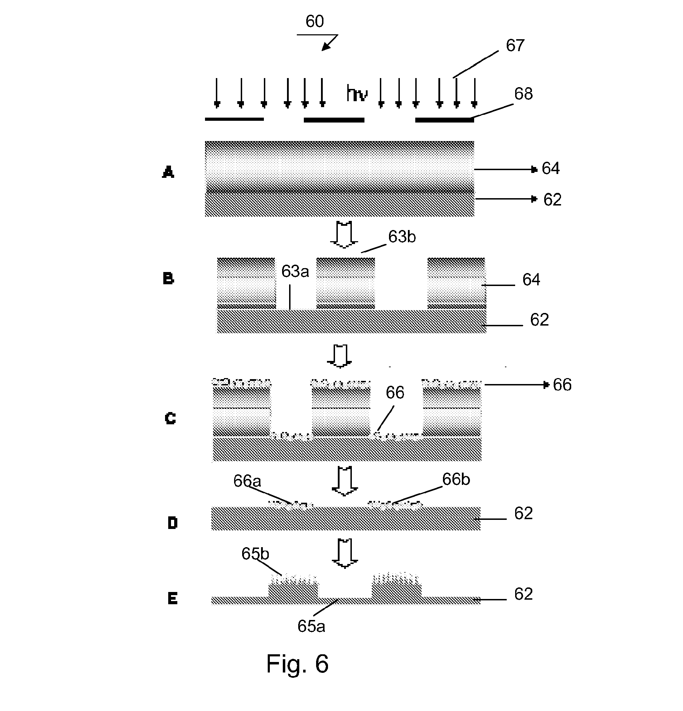

Figure 6 presents in a schematic way a still further embodiment of the method according to the invention. In this particular embodiment a still further aspect of the invention is presented, wherein regions of different roughness in the template are inherently provided.

At step A a substrate 62 provided with a photoresist layer 64 is exposed by a suitable radiation 67, for example, via a mask 68. At step B, post developing, a two-dimensional pattern is provided, having a first surface region corresponding to the revealed substrate 63a and a second surface region corresponding to the remaining photoresist 63b.

At step C suitable nanoparticles 66 are deposited on both, the surface 63a and the surface 63b. For example, the nanoparticles may be deposited as a suitable film on the grooves 63a and the protrusions 63b.

At step D a lift-off is carried out, which is accompanied by removal of photoresist, while the nanoparticles 66a, 66b deposited in the grooves remain on the substrate.

At step E selective etching of the substrate 62 is carried out, wherein the nanoparticles are used as a mask. Accordingly, the etching process will have a different rate at regions covered by the nanoparticles compared to the regions not covered by the nanoparticles. As a result selective and controlled surface roughening is obtained, wherein the resulting surface area has different regions 65a, 65b having different roughness.

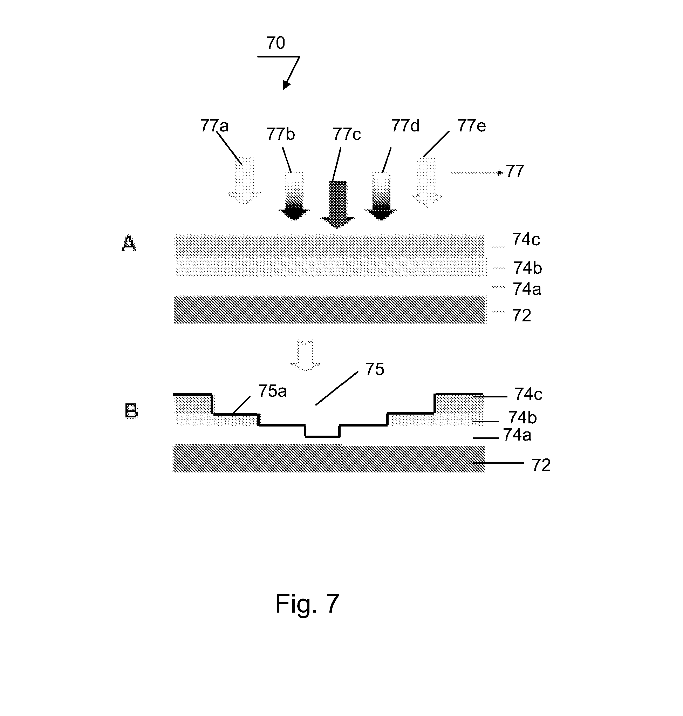

Figure 7 presents in a schematic way a still further embodiment of the method according to the invention. In this particular embodiment a suitable substrate 72 is provided with a number of layers of photoresist 74a, 74b, 74c, wherein each layer may have differently sized nanoparticles there within. Additionally or alternatively, the photoresist layers may have nanoparticles of different nature.

At step A the substrate together with the photoresist layers 74a, 74b, 74c is exposed by a radiation beam 77, which may comprise a number of components 771, 77b, 77c, 77d, 77e, having different energy. As a result an inhomogeneous beam in terms of energy is used for exposing the photoresist layers 74a, 74b, 74c.

At step B post development, a cavity 75 is provided, which comprises a plurality of sub-regions of the surface 75a, each sub-region originating from a particular photoresist layer 74a, 74b, 74c. In order to induce different respective roughness to the sub-regions, each sub-layer 74a, 74b, 74c may be provided with different embedded nanoparticles. The nanoparticles may differ in dimension and/or in nature.

It will be appreciated that while specific embodiments of the invention have been described above, that the invention may be practiced otherwise than as described. In addition, isolated features discussed with reference to different figures may be combined. It will be further appreciated that, when context allows, the term 'hydrophobic' may be replaced by the term 'hydrophilic', such as the described surface structuring is used for enchancing a starting wettability condition of the substrate. For example, an initially hydrophilic surface may modified for enchancing a degree of wettability.

## Claims

1. A method of fabrication of a substrate having a first region with a first wettability degree and a second region with a second wettability degree, the method comprising the steps of:
- providing the substrate with a roughened surface of a photosensitive layer using embedded nano- and/or microparticles;
- transferring a pattern into the photosensitive layer for obtaining a substrate structure;
- developing the substrate structure for obtaining the first region corresponding to the substrate and the second region corresponding to the roughened photosensitive layer.

2. A method according to claim 1, further comprising a step of removing a top portion of the roughened photosensitive layer.

3. A method according to claim 2, wherein said step is carried out by means of a partial development of the roughened photosensitive layer.

4. A method according to claim 2 or 3, wherein a thickness of the said top portion is less than a diameter of the nano- and/or microparticles embedded in the photosensitive layer.

5. A method according to any one of the preceding claims, further comprising the step of removing the embedded nano- and/or microparticles from a surface area of the substrate structure.

6. A method according to claim 5, wherein the nano- and/or microparticles are removed using etching.

7. A method according to claim 6, wherein etching is carried out in fluorine or in chlorine atmosphere.

8. A method according to any one of the preceding claims, further comprising the step of providing the substrate structure with an anti-sticking layer.

9. A method according to claim 8, wherein for the anti-sticking layer a fluorine-containing material, or a Si-containing material is selected.

10. A method according to any one of the preceding claims, further comprising the step of etching a photosensitivet material for further roughening a surface of the substrate structure.

11. A method according to any one of the preceding claims, wherein the second region is more hydrophobic than the first region.

12. A method of fabrication of a substrate having a first region with a first wettability degree and a second region with a second wettability degree, the method comprising the steps of:
- roughening the substrate for forming a structured substrate surface;
- providing a photosensitive layer on the structured substrate surface;
- patterning and developing the photosensitivet layer for revealing regions of the structured substrate surface.

13. A method according to claim 12, wherein for the step of roughening a technique is selected from a group consisting of: etching, grinding, sand blasting, ion bombardment, machining.

14. A method according to claim 12, wherein for the substrate a monocrystalline Si substrate is selected, said roughening being carried out using etching along the 100 direction of the silicon crystal.

15. A method according to claim 12, 13 or 14, wherein the photosensitive layer comprises nano- and/or microparticles.

16. A method of fabrication of a substrate having a first region with a first wettability degree and a second region with a second wettability degree, the method comprising the steps of:
- exposing a substrate provided with a photosensitive layer by a laser beam having a pre-determined inhomogeneous profile for obtaining a set of cavities in the photosensitive layer;
- developing the exposed photosensitive layer yielding the structured substrate.

17. A method of fabrication of a substrate having a first region with a first wettability degree and a second region with a second wettability degree, the method comprising the steps of:
- exposing the substrate provided with a photosensitive film by radiation;
- developing the photosensitive layer for revealing regions of the substrate;
- depositing nano- and/or microparticles at least on the regions of the substrate;
- removing the photosensitive layer;
- selectively etching the substrate for obtaining the first region corresponding to substrate areas not covered by the nano- and/or microparticles and the second region corresponding to areas covered by the nano- and/or microparticles.

18. A method of fabrication of a substrate having a first region with a first wettability degree and a second region with a second wettability degree, the method comprising the steps of:
- exposing the substrate provided with a photosensitive layer composed on a number of sub-layers having individual roughness by a laser beam having a pre-determined inhomogeneous energy profile for obtaining a cavity in the photosensitive layer, said cavity comprising surface portions corresponding to said sub-layers;
- developing the exposed photosensitive layer yielding a multi-level substrate.

19. A method according to claim 18, wherein the photosensitive layer comprises a number of sub-layers having embedded nano- and/or microparticles of pre-selected different dimensions or different type.

20. A method according to claim 18 or 19, wherein the energy is selected to decrease towards exterior of the laser beam.

21. A method according to any one of the preceding claims further comprising the step of replicating the substrate structure into a mold.
